# EUROPEAN PATENT APPLICATION

(11) **EP 3 246 926 A1**
(43) Date of publication of application: **22.11.2017**
(21) Application number: 16170552.0
(22) Date of filing: 20.05.2016
(51) Int. Cl.: H01F 3/02, H01F 41/02, H01F 3/10

(54) **MAGNETIC FLUX CONCENTRATOR STRUCTURE AND METHOD FOR MANUFACTURING THE SAME**

(71) Applicant: Melexis Technologies SA, 2022 Bevaix (CH)
(72) Inventor: RACZ, Robert, 6300 Zug (CH); SPATARU, Amalia-Ioana, 2000 Neuchâtel (CH)
(74) Representative: DenK iP

(57) **Abstract**

The present invention relates to a method for manufacturing a magnetic flux concentrator structure (10). The method comprises
- providing a first stack (1) comprising a plurality of laminated layers of a first soft ferromagnetic material,
- providing a second stack (2) comprising a plurality of laminated layers of a second soft ferromagnetic material having a different magnetic hysteresis from said first soft ferromagnetic material,
- annealing separately said first and said second stack,
- assembling said annealed first stack and said annealed second stack to obtain said magnetic flux concentrator structure (10).

## Description

### Field of the invention

The present invention is generally related to the field of ferromagnetic cores as used in various types of current sensors. The invention also relates to the field of methods for producing such ferromagnetic cores.

### Background of the invention

A magnetic core is a piece of magnetic material with a high magnetic permeability used to confine and guide magnetic fields in electrical, electromechanical and magnetic devices. Magnetic cores are used in many applications, like e.g. in current sensors (i.e. Hall-Current sensors, current transformers, energy meters...). Such magnetic cores are typically made of soft ferromagnetic materials or compounds with high permeability. This high permeability, relative to the surrounding air, causes the magnetic field lines to be concentrated in the core material. In this way all magnetic flux can be guided.

One of the main challenges faced when designing magnetic cores is the non-linearity and saturation of the magnetic materials, as well as the presence of magnetic hysteresis, reducing the magnetic performance. These parasitic effects limit the current sensor accuracy (linearity, offset, resolution).

Additionally, when a magnetic core operates under a high frequency magnetic field (transformer, current sensors, etc), intense eddy currents can appear due to the magnetic field variation, resulting in losses and compromising the frequency performance.

In order to be able to guide large magnetic fluxes generated by high currents as occurring e.g. in power applications, not only the magnetic cores airgap but also the magnetic core cross-section need to be increased in order to maintain a linear behavior of the magnetic flux. This increase in size obviously has a direct impact on the cost of the core. This is particularly important for high volume applications, like in (hybrid) electric vehicles, where currents in the range of typically 0 to 500 A or even up to 2000A need to be sensed.

In view of these issues, new magnetic compounds and alloys have been developed to obtain a higher performance/cost ratio. In particular, NiFe alloys are commonly used in the industry due to their good soft ferromagnetic properties, like good linearity, very high permeability and low hysteresis. This alloy, although providing a high performance solution, remains a costly solution for high mass production given the nickel cost as well as the magnetic core size given its magnetic field saturation of typically 0.75-1.5 T.

Other lower performance materials, such as SiFe cores, are commonly used in the industry mainly due to their lower cost and higher saturation (typically 1.8-2T). Due to their higher hysteresis, however, they compromise the performance, as the hysteresis generates an error signal (offset) in a core based current sensor.

In order to limit the eddy currents, cores are generally laminated, i.e. they are made of thin, soft-magnetic sheets (typically 0.2-0.5mm thickness but possibly as thick as the full core, i.e. no lamination layer), positioned, as much as possible, in parallel with the lines of flux. Using this technique, the magnetic core is equivalent to a plurality of individual magnetic cores. Because eddy currents flow around lines of flux, the lamination prevents most of the eddy currents from flowing at all.

Hence, there is a need for a magnetic core with improved performance that can be obtained at an acceptable cost.

### Summary of the invention

It is an object of embodiments of the present invention to provide for a method for manufacturing a magnetic flux concentrator structure that yields high performance while keeping the cost low.

The above objective is accomplished by the solution according to the present invention.

In a first aspect the invention relates to a method for manufacturing a magnetic flux concentrator structure. The method comprises
- providing a first stack comprising a plurality of laminated layers of a first soft ferromagnetic material,
- providing a second stack comprising a plurality of laminated layers of a second soft ferromagnetic material having a different magnetic hysteresis than said first soft ferromagnetic material,
- annealing separately the first stack and the second stack,
- assembling the annealed first stack and the annealed second stack to obtain said magnetic flux concentrator structure.

The proposed solution indeed allows achieving a higher ratio of performance to cost. Due to the fact that the two stacks are produced independently from one another, in particular annealed independently from each other, mechanical stress is avoided. The two soft ferromagnetic materials at least have a different magnetic hysteresis. Thanks to the lower magnetic hysteresis in one material there is less contribution of the structure to the overall system offset. Due to the use of a lower quality soft magnetic material in the second stack, the cost of the magnetic flux concentrator structure can be kept relatively low. Moreover, the proposed magnetic flux concentrator structure features a wide frequency range and current range.

In an advantageous embodiment the second soft ferromagnetic material has a different magnetic permeability than the first soft ferromagnetic material.

In another advantageous embodiment the second soft ferromagnetic material has a different magnetic saturation level than the first soft ferromagnetic material.

In a preferred embodiment the first soft ferromagnetic material is a FeNi alloy (e.g. Mu Metal, Permalloy, Supra50, ...). This is then the high quality material with good soft ferromagnetic properties, in particular low hysteresis and very high permeability.

In one embodiment the second soft ferromagnetic material is a type of FeSi alloy (e.g. grain-oriented electrical steel or non-grain oriented electrical steel, e.g. ThyssenKrupp 390-50PP-C6W).

In another embodiment the method further comprises : providing a third stack of soft ferromagnetic material, said third stack comprising a plurality of laminated layers, and separately annealing that third stack.

Advantageously, the laminated layers of the third stack are of the first soft ferromagnetic material, i.e. the high quality material. Alternatively, the laminated layers of the third stack are made of a third soft ferromagnetic material different from the first and the second material, and thus with different magnetic properties.

In one embodiment the second stack is then assembled in between the first and the third stack, i.e. between the two stacks in high quality material.

In yet another embodiment a pre-molded package is employed in the assembling step for inserting the various stacks. Advantageously, the first and second stack, and optionally, if present, the third stack comprise mechanical notches and the pre-molded package is accordingly adapted to receive said mechanical notches allowing a good alignment without adding mechanical stress.

In another aspect the invention relates to a magnetic flux concentrator structure comprising an assembly of an annealed first stack and an annealed second stack, said first stack comprising a plurality of laminated layers of a first soft ferromagnetic material and said second stack comprising a plurality of laminated layers of a second soft ferromagnetic material having a different magnetic hysteresis than the first soft ferromagnetic material.

In another aspect the invention relates to a magnetic flux concentrator structure comprising an assembly of an annealed first stack and an annealed second stack, wherein said first and said second stack have been annealed independently from one another and wherein said first stack comprises a plurality of laminated layers of a first soft ferromagnetic material and said second stack comprises a plurality of laminated layers of a second soft ferromagnetic material having a different magnetic hysteresis than the first soft ferromagnetic material.

In a preferred embodiment the second stack has a greater thickness than the first stack.

In another embodiment the structure is C-shaped and the length of the air gap of the C-shape exceeds the total thickness of the stacks of the magnetic flux concentrator structure. Alternatively, the length of the air gap of the C-shape can be smaller than the total thickness of the stacks.

In another embodiment the air gap is different for the first stack than for the second stack.

In another aspect the invention relates to a current sensor or energy meter comprising a magnetic flux concentrator structure as previously described.

In more specific embodiments the current sensor or energy meter further comprises a Hall sensor, an AMR/GMR sensor or a flux gate sensor.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates an embodiment of the magnetic flux concentrator structure of this invention.
Fig.2 illustrates an embodiment with three stacks.
Fig.3 illustrates an embodiment with three stacks wherein the outer layers are in the same high grade soft ferromagnetic material.
Fig.4 illustrates an embodiment with three stacks wherein the outer layers are in the same high grade soft ferromagnetic material and wherein the length of the air gap is different for the outer layers than for the inner layer.
Fig.5 illustrates a premolded package and a stack provided with mechanical notches.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention discloses a laminated magnetic flux concentrator structure comprising at least two stacks of different ferromagnetic material in order to offer the best possible performance while maintaining a reduced cost.

By having at least one stack of laminated layers in a higher performance soft magnetic material the proposed magnetic core structure can obtain an enhanced performance compared to what is achievable when only soft magnetic material with higher hysteresis and lower permeability is used.

In other words, by combining a high saturation compound/alloy stack with a low hysteresis stack, the best of both worlds can be achieved, in that the high field saturation material allows guaranteeing a high operational range, while the low hysteresis material guarantees good performance at low signals (currents).

In electric vehicles or hybrid electric vehicles, for example, the torque of the traction motor is controlled by the current driving the electric motor. High current values occur when driving fast or when a high torque is required, but e.g. when the vehicle is in parking mode or driving very slowly, only a very small current is present. Then low hysteresis becomes important, as it generates an offset voltage in the current sensor, which obviously should be kept as small as possible. Sufficient accuracy is desired for the current measurement, therefore good linear behaviour is required.

In one embodiment the magnetic flux concentrator structure is built of one stack of low cost laminated FeSi alloy with two smaller stacks of high grade FeNi lamination. As SiFe has a higher saturation field, such embodiment offers the additional benefit of a space reduction.

In the manufacturing process each stack is annealed at a material specific temperature. Usually, different materials require different annealing temperatures. For example, the typical temperature for magnetic annealing is about 880°C for FeSi Steel and about 1150°C for 48% NiFe alloy. The hybrid core structure of this invention allows manufacturing a magnetic core with independent annealing of each of the laminated stacks given the specific requirements of each alloy and allows a final assembly without introduction of any mechanical stress. This can be achieved, for example, due to a pre-molded envelope, wherein the annealed stacks of layers can be inserted and finally potted. The pre-molded envelope is then so designed that it can receive the stacks provided with mechanical marks/guides, i.e. notches.

The invention also relates to a current sensor comprising a magnetic flux concentrator structure as described. The current sensor can be implemented as a Hall current sensor, a current transformer, ... The sensor may also be anisotropic magnetoresistance or a giant magneto resistant (AMR/GMR).

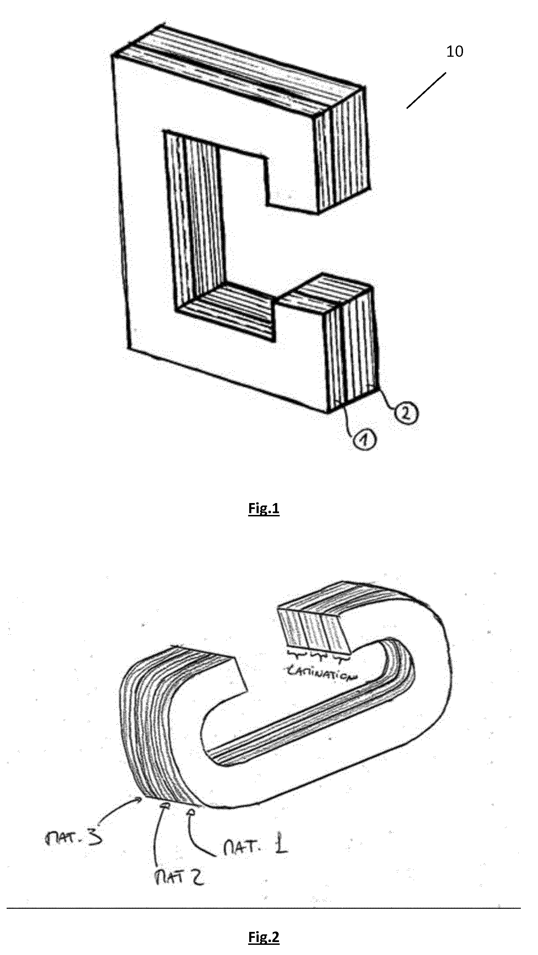

Fig.1 illustrates an embodiment of a magnetic flux concentrator structure (10) according to the invention. The figure shows a first annealed stack (1) and a second, separately annealed stack (2) assembled together to form the resulting structure (10). The laminated layers of the two stacks are made of two different soft magnetic materials, with different magnetic properties. One of the stacks is in a high grade material, whereas the other yields a somewhat lower performance.

Advantageously the structure comprises a third stack, which also comprises a number of laminated layers. The third stack is independently annealed, just as the first and second stack. Next the three stacks are assembled. Fig.2 provides an illustration of the resulting magnetic flux concentrator structure. The structure shown in Fig.2 is C-shaped.

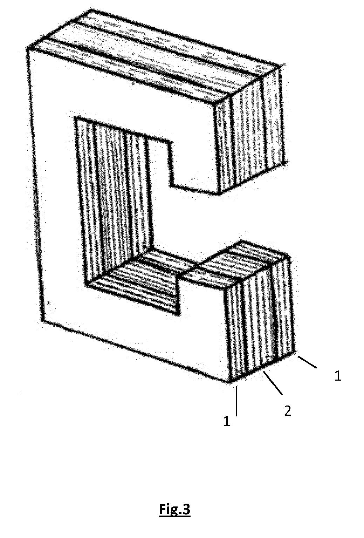

In a preferred embodiment the third stack is made of the same high quality soft ferromagnetic material as one of the other two stacks. When assembling the various stacks, the two high performance stacks (1) are placed at either side of the stack (2) in lower performance material. This is illustrated in Fig.3. Again a C-shaped structure is illustrated. The air gap of the core between the two 'arms' of the C has the same length for both materials in the shown embodiment.

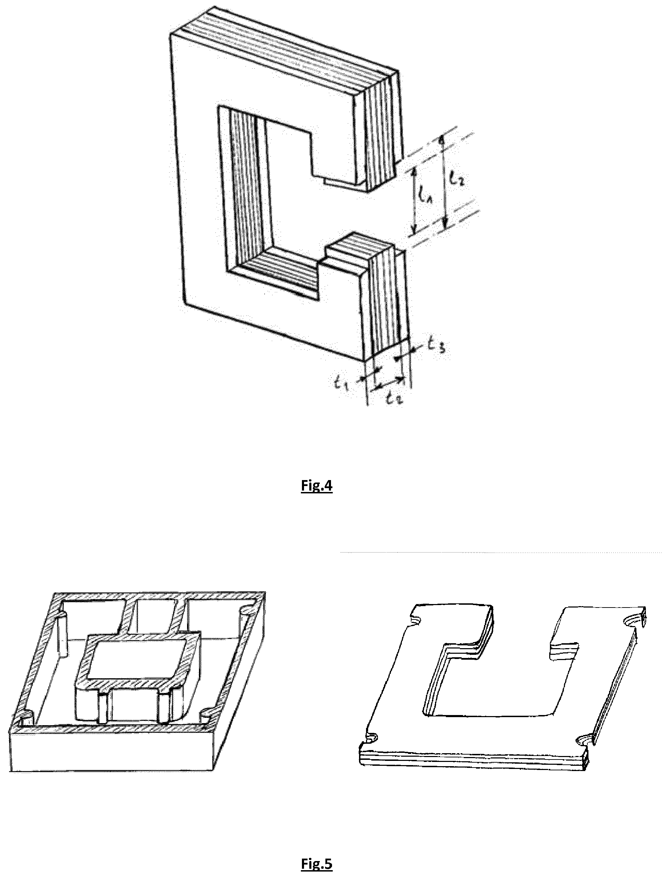

Fig.4 illustrates an embodiment wherein the magnetic flow concentrator structure has a C-shape, wherein the air gap is larger for the first stack (I₂) with the high grade material than for the second stack (I₁) with the material of lower quality. Fig.4 also illustrates that in a preferred embodiment the stack in lower performance material is thicker than the high performance stacks, i.e. t₁ and t₃ are smaller than t₂. The thickness of all stacks together then is t = t₁+t₂+t₃. This obviously is beneficial in terms of cost.

Typically, the one or more high performance stacks do not represent more than 50 % of the total amount of material of the structure.

Fig.5 illustrates a pre-molded package (left hand side) and mechanical notches provided in a stack (right hand side).

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Method for manufacturing a magnetic flux concentrator structure (10) comprising
- providing a first stack (1) comprising a plurality of laminated layers of a first soft ferromagnetic material,
- providing a second stack (2) comprising a plurality of laminated layers of a second soft ferromagnetic material having a different magnetic hysteresis than said first soft ferromagnetic material,
- annealing separately said first stack and said second stack,
- assembling said annealed first stack and said annealed second stack to obtain said magnetic flux concentrator structure (10).

2. Method for manufacturing a magnetic flux concentrator structure as in claim 1, wherein said second soft ferromagnetic material has a different magnetic permeability than said first soft ferromagnetic material.

3. Method for manufacturing a magnetic flux concentrator structure as in claim 1 or 2, wherein said second soft ferromagnetic material has a different magnetic saturation level than said first soft ferromagnetic material.

4. Method for manufacturing a magnetic flux concentrator structure as in any of claims 1 to 3, wherein said first soft ferromagnetic material is a FeNi alloy.

5. Method for manufacturing a magnetic flux concentrator structure as in any of claims 1 to 4, wherein said second soft ferromagnetic material is a FeSi alloy or a ferrite.

6. Method for manufacturing a magnetic flux concentrator structure as in any of the previous claims, comprising :
- providing a third stack of soft ferromagnetic material comprising a plurality of laminated layers, and separately annealing said third stack.

7. Method for manufacturing a magnetic flux concentrator structure as in claim 6, wherein said plurality of laminated layers of said third stack are of said first soft ferromagnetic material.

8. Method for manufacturing a magnetic flux concentrator structure as in claim 6 or 7, further comprising assembling said second stack in between said first and said third stack.

9. Method for manufacturing a magnetic flux concentrator structure as in any of the previous claims, wherein said assembling comprises the use of a pre-molded package to insert said stacks.

10. Method for manufacturing a magnetic flux concentrator structure as in claim 9, wherein said first and said second stack comprise mechanical notches and wherein said pre-molded package is adapted to receive said mechanical notches.

11. Magnetic flux concentrator structure comprising an assembly of an annealed first stack and an annealed second stack, said first stack comprising a plurality of laminated layers of a first soft ferromagnetic material and said second stack comprising a plurality of laminated layers of a second soft ferromagnetic material having a different magnetic hysteresis than said first soft ferromagnetic material.

12. Magnetic flux concentrator structure as in claim 11, wherein said second stack has a greater thickness than said first stack.

13. Magnetic flux concentrator structure as in any of claims 11 to 12, having a C-shape, whereby the length of the air gap of said C-shape exceeds the thickness of the magnetic flux concentrator structure.

14. Magnetic flux concentrator structure as in any of claims 11 to 13, wherein the air gap of said C-shape is different for the first stack than for the second stack.

15. Current sensor comprising a magnetic flux concentrator structure as in any of claims 11 to 14.
